Europäisches Patentamt

European Patent Office

Office européen des brevets

(11) Publication number:
**0 360 558**
**A2**

## (12) EUROPEAN PATENT APPLICATION

(21) Application number: **89309507.5**

(22) Date of filing: **19.09.89**

(51) Int. Cl.⁵: **H 01 R 23/66**

(30) Priority: **21.09.88 JP 122851/88**

(43) Date of publication of application:
**28.03.90 Bulletin 90/13**

(84) Designated Contracting States:
**BE CH DE ES FR GB IT LI LU NL SE**

(71) Applicant: **THOMAS & BETTS CORPORATION**
**1001 Frontier Road**
**Bridgewater New Jersey 08807 (US)**

(72) Inventor: **Yamada, Yoshio Lainesuheim Tunashima 1-609**
**Shinyoshida-cho 1510 Kohhoku-ku**
**Yokohama City Kanagawa Pref. (JP)**

(74) Representative: **Howick, Nicholas Keith et al**
**CARPMAELS & RANSFORD 43 Bloomsbury Square**
**London WC1A 2RA (GB)**

(54) Shielded jumper.

(57) A shielded jumper comprises a plurality of conductors (1) extending parallel to each other and spaced apart from each other at a predetermined pitch, a first insulating layer (2) for covering said plurality of conductors except for lead portions (10, 11) thereof, a thin conductive shield layer (3) which overlaps at least one surface of the first insulating layer, and a ground pin (4) including a connecting portion (41) which extends through said shield layer and said first insulating layer from the outside of said shield layer and is connected to at least one of said plurality of conductors, and a leg (42) overlying a conductor lead connected by said connecting portion.

Fig. 1

Description

# SHIELDED JUMPER

The present device relates to a jumper used to connect, e.g., printed circuit boards and, more particularly, to a jumper having a shield layer thereon.

Prior Art

Known is a conventional jumper of this type wherein conductors are parallel to each other and spaced apart from each other at a predetermined pitch, and the conductors are covered with an insulating layer except for lead portions at both ends thereof.

Electronic components such as printed circuit boards and display panels connected using the above jumper are often used in severe electrical and mechanical conditions. For example, in an ECU (Engine Control Unit) for an automobile, the components are exposed to ignition noise and noise from other components and tend to fail. Therefore, under these severe conditions, the jumper itself for connecting a circuit board must be shielded to eliminate electromagnetic intereference.

Object of the Device

The present device has been developed in consideration of the above situation, and has as its object to solve the conventional problem such that a conductive shield layer is formed on at least one surface of the jumper, and the shield layer is connected to at least one of the conductors through a ground pin to shield the jumper itself.

The invention provides a shielded jumper comprising:
a plurality of conductors extending parallel to each other and spaced apart from each other at a predetermined pitch;
a first insulating layer for covering said plurality of conductors except for lead portions thereof;
a thin conductive shield layer which overlaps at least one surface of the first insulating layer; and
a ground pin including a connecting portion which extends through said shield layer and said first insulating layer from the outside of said shield layer and is connected to at least one of said plurality of conductors, and a leg overlying a conductor lead connected by said connecting portion.

By way of example, one embodiment of a shielded jumper according to the invention will now be described with reference to the accompanying drawings, in which:-

Figure 1 is a front view of a shielded jumper according to the invention;

Figure 2 is a side view of the shielded jumper of Figure 1; and

Figure 3 is a partially cutaway perspective view for explaining a connecting state between the pin and the conductor.

Description of the Preferred Embodiment

The present device will be described in detail with reference to a preferred embodiment.

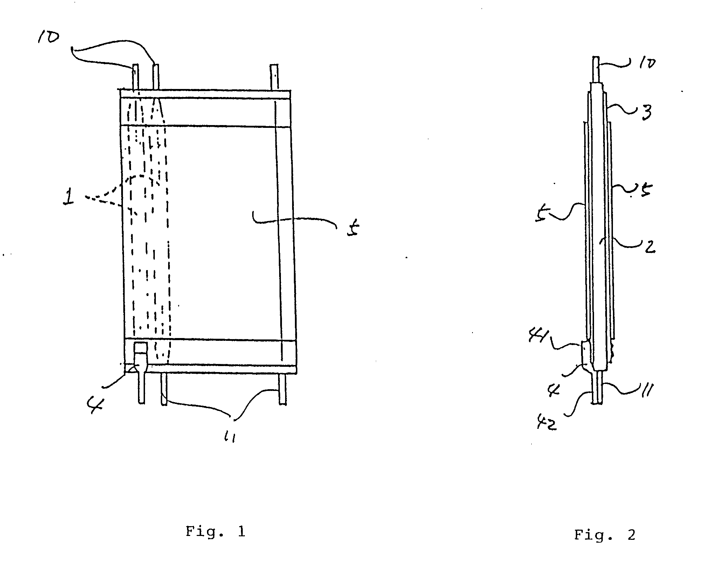

Referring to Figure 1, reference numerals 1 denote conductors extending parallel to each other and spaced apart from each other at a predetermined pitch. These conductors are flat except for lead portions 10, 11 at their both ends. The flat portion is entirely covered with a first insulating layer 2. Reference numeral 3 denotes a thin conductive shield layer overlying at least one surface of the first insulating layer. The shield layer comprises, e.g., an aluminium foil.

Ground pins 4 are connected to at least one of the plurality of conductors 1 from the outside of the shield layer 3. The connected conductor serves as a ground conductor, so that a corresponding pattern on a printed circuit board is grounded.

Each pin 4 comprises a connecting portion 41 extending through the shield layer 3 and the first insulating layer 2 and connected to the conductor 1, and a leg 42 overlying a lead 11 of the conductor.

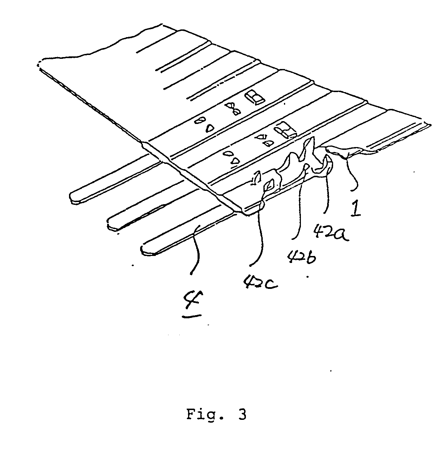

In the embodiment, the connecting portion 41 of the pin 4 has knife edges 42a, 42b, and 42c, as shown in Figure 3. These knife edges extend through the shield layer 3 and the insulating layer 2 as well as the flat portion of the corresponding conductor 1, thereby caulking the conductor as shown in Figure 3.

Figure 2 is a side view showing the embodiment of Figure 1. As is apparent from Figure 2, the leads 11 of the jumper overlap the legs 42 of the pins 4, and the overlapping portion is inserted in, e.g., a lead insertion hole of a printed circuit board and is soldered thereto.

In the illustrated embodiment, a second thin insulating layer 5 is formed on the shield layer 3 to protect the shield layer.

Effect of the Device

The structure of the jumper according to the present device is as described above, and the present device has the following effects.

According to the present device, the shield layer overlaps the surface of the jumper layer, and the shield layer and the lead of the jumper are connected through the ground conductive pin. Therefore, electromagnetic interference such as external noise and the like can be minimised.

Claims

1. A shielded jumper comprising:
a plurality of conductors (1) extending parallel to each other and spaced apart from each other at a predetermined pitch;
a first insulating layer (2) for covering said plurality of conductors except for lead portions (10, 11) thereof;
a thin conductive shield layer (3) which overlaps at least one surface of the first insulating layer; and
a ground pin (4) including a connecting portion (41) which extends through said shield layer and said first insulating layer from the outside of said shield layer and is connected to at least one of said plurality of conductors, and a leg (42) overlying a conductor lead connected by said connecting portion.

2. A shielded jumper according to Claim 1, wherein a thin second insulating layer (5) overlaps said shield layer.

3. A shielded jumper according to Claim 1 or Claim 2, characterised in that each of the conductors has a flat portion covered with said first insulating layer, and said ground pin is connected to said flat conductor portion.

Fig. 2

Fig. 1

1

42a

42b

42c

4

Fig. 3